# FASCICULE DE BREVET EUROPEEN

(11) **EP 0 370 923 B1**
(45) Date de publication et mention de la délivrance du brevet: **07.09.1994**
(21) Numéro de dépôt: 89420437.9
(22) Date de dépôt: 13.11.1989
(51) Int. Cl.: G01R 29/08, G01R 29/12, G01W 1/16

(54) **Procédé et appareil pour la détection d'impulsions dues à des décharges électrostatiques de mobilier ou humaines**
Verfahren und Vorrichtung zur Detektion von Impulsen, veranlasst durch elektrostatische Entladungen von Körpern
Method and apparatus for the detection of pulses caused by domestic or human electrostatic discharges

(30) Priorité: 14.11.1988 FR 8815074
(43) Date de publication de la demande: 30.05.1990
(73) Titulaire: Delcourt, Gilles, F-69110 Sainte Foy Les Lyon (FR)
(72) Inventeur: Delcourt, Gilles, F-69110 Sainte Foy Les Lyon (FR)
(74) Mandataire: Ropital-Bonvarlet, Claude

(56) Documents cités:
- FR-A- 2 352 304
- US-A- 3 790 884
- US-A- 4 007 418
- US-A- 4 631 473
- PATENT ABSTRACTS OF JAPAN, vol. 153, no. 4 (P-033), 25 octobre 1980;& JP-A-55101 071 (KATO GIICHIRO) 01-08-1980

## Description

### PROCEDE ET APPAREIL POUR LA DETECTION D'IMPULSIONS DUES A DES DECHARGES ELECTROSTATIQUES DE MOBILIER OU HUMAINES

La présente invention concerne le domaine technique de la détection des impulsions brèves générant des hautes fréquences et susceptibles d'apparaître, plus particulièrement, dans L'environnement du matériel informatique au sens général, c'est-à-dire tout système comportant des circuits logiques de traitement de l'information.

Le matériel informatique est constitué, en majeure partie, par des composants électroniques qui sont, par nature, très sensibles aux moyennes et hautes fréquences. Il s'ensuit que le matériel informatique présente des dysfonctionnements aléatoires en présence de telles fréquences. Or, l'expérience pratique montre que le local ou l'environnement, dans lequel est installé le matériel informatique, constitue un endroit où règne fréquemment des hautes et moyennes fréquences.

Il apparaît que les hautes fréquences sont engendrées par des impulsions brèves, résultant, principalement, de deux phénomènes. Le premier est relatif aux impulsions brèves de commutation au sens général, provenant, par exemple, de la fermeture de relais ou d'interrupteurs. Le second concerne les impulsions brèves résultant de décharges électrostatiques dites de mobilier ou humaines.

L'état de la technique a proposé, par le brevet **US-A-3 790 884,** un appareil assurant la détection des impulsions de moyennes fréquences apparaissant lors d'un orage. Cet appareil permet de déceler, dans un endroit géographique déterminé, à l'aide d'une antenne de 30 mètres et placée à 7 mètres du sol, la présence d'orages sévères présentant des caractéristiques spécifiques. Cet appareil vise à détecter les maxima et les minima des variations du champ électrostatique évoluant dans L'endroit géographique donné. En considérant une courbe représentant le champ électrostatique en fonction du temps, les minima et les maxima correspondent aux portions de courbe où la pente est nulle. L'appareil assure, également, la détection d'un champ électromagnétique dû à des décharges atmosphériques à l'aide d'un filtre passe bande centrée à une fréquence de 455 kHz et d'une largeur de 3 Hz. Un orage sévère est détecté lorsque, d'une part, quinze maxima ou minima du champ électrostatique sont détectés dans un intervalle de temps de 1 minute et, d'autre part, lorsque, par minute, apparaissent 2 800 impulsions électromagnétiques dues à des décharges atmosphériques.

Dans le même sens, le document **JP-54 008 998** concerne un appareil d'observation des phénomènes météorologiques visant à détecter simultanément la variation du champ électrostatique et une impulsion électromagnétique.

De tels appareils permettent donc de déceler des phénomènes météorologiques intervenant dans un lieu géographique donné, mais ne se trouvent pas adaptés pour déterminer le phénomène ayant produit des impulsions dans un local donné contenant un matériel informatique, en raison du principe même de détection et des moyens techniques mis en oeuvre.

L'état de la technique connaît, également, notamment par la demande de brevet **FR-A-2 352 304**, des systèmes de détection d'impulsions brèves, consistant à déceler, par l'intermédiaire d'une antenne, la composante électrique ou la composante magnétique du champ électromagnétique engendré par ces impulsions brèves.

Le brevet **US-A-4 631 473** décrit un système de détection d'impulsions consistant à détecter le champ électromagnétique par un filtre passe-haut et à produire un signal d'avertissement. Dans le même sens, le brevet **US-A-4 007 418** concerne un système permettant de détecter la variation du champ électrostatique et de produire un signal d'avertissement lorsque la variation du champ électrostatique atteint un taux suffisant.

Toutefois, de tels systèmes connus de l'art antérieur ne permettent pas de déterminer le phénomène ayant produit ces impulsions brèves, ce qui représente un inconvénient important, dans la mesure où les solutions techniques à apporter pour s'affranchir de l'effet des impulsions brèves dépendent du phénomène les ayant engendrées.

Il apparaît donc le besoin de disposer de moyens permettant de déterminer l'origine des impulsions brèves, apparaissant dans un local, de manière à mettre en oeuvre des solutions techniques spécifiquement adaptées aux phénomènes existants dans l'environnement du matériel informatique.

La présente invention vise donc à satisfaire ce besoin en proposant un procédé pour détecter les impulsions brèves dues aux décharges électrostatiques, dites de mobilier ou humaines, permettant de déterminer l'origine des dysfonctionnements aléatoires du matériel informatique et de mettre en oeuvre des solutions techniques adaptées à l'origine du dysfonctionnement.

L'invention a pour objet, également, de proposer un appareil permettant la mise en oeuvre du procédé, de conception simple et d'un coût de fabrication limité.

Pour atteindre les buts ci-dessus, le procédé de détection, à l'intérieur d'un local, d'impulsions résultant de décharges électrostatiques, notamment de mobilier ou humaines, est du type selon lequel le champ électromagnétique est détecté à L'intérieur du local par un filtre passe-haut. Le procédé selon l'invention est caractérisé en ce qu'il consiste à :
- détecter, à L'intérieur du local, d'une part, le champ électromagnétique par le filtre passe-haut dont la fréquence de coupure est comprise entre 15 et 200 MHz et, d'autre part, le champ électrostatique,
- détecter la première variation du champ électrostatique intervenant dans un temps inférieur à 1 milliseconde,
- et à produire un signal d'avertissement lorsque la variation du champ électrostatique détectée et la présence du champ électromagnétique interviennent simultanément dans un intervalle de temps inférieur à 1 milliseconde, permettant d'identifier une impulsion due à une décharge électrostatique mobilière ou humaine.

Diverses autres caractéristiques ressortent de la description faite ci-dessous en référence aux dessins annexés qui montrent, à titre d'exemples non limitatifs, des formes de réalisation de l'objet de l'invention.

La **fig. 1** est une vue d'un schéma-bloc fonctionnel d'un appareil permettant la mise en oeuvre du procédé de détection conforme à l'invention.

La **fig. 2** illustre un exemple de réalisation d'un appareil de détection conforme à l'invention.

Le procédé selon l'invention vise à détecter des impulsions brèves dues à des décharges électrostatiques, dites de mobilier ou humaines, et susceptibles d'intervenir dans l'environnement d'un matériel informatique au sens général. Le procédé selon l'invention consiste à procéder localement, dans l'environnement du matériel informatique, à la détection, à la fois d'un champ électromagnétique et d'un champ électrostatique. Le procédé consiste à détecter la première variation du champ électrostatique préalablement détecté et intervenant dans un intervalle de temps déterminé. Un signal d'avertissement est alors généré lors de la présence simultanée du champ électromagnétique produit par une impulsion brève due à une décharge électrostatique et d'une variation du champ électrostatique détectée. L'apparition d'un tel signal d'avertissement permet d'identifier une impulsion due à une décharge électrostatique, dite de mobilier ou humaines, qui se traduit par une variation rapide du champ électrostatique donnant lieu à l'apparition d'une impulsion dont le champ électromagnétique qu'elle génère est, simultanément, détecté.

Il doit être considéré que le procédé vise à détecter les variations du champ électrostatique intervenant dans un temps inférieur ou égal à 1 milliseconde, de manière à ne prendre en compte que les variations de champ électrostatique correspondant à des décharges électrostatiques et non à de simples fluctuations du champ. De plus, le champ électromagnétique est détecté à l'aide d'un filtre passe-haut dont la fréquence de coupure est comprise entre 15 MHz et 200 MHz. Par ailleurs, il doit être noté que le signal d'avertissement est généré lorsque la variation du champ électrostatique détectée et un champ électromagnétique apparaissent à la fois, dans un intervalle de temps inférieur à 1 milliseconde. Ce terme simultané doit donc être compris comme correspondant à un intervalle de temps inférieur à 1 milliseconde. De plus, le procédé vise à détecter la première variation du champ électrostatique intervenant dans un intervalle de temps inférieur à 1 milliseconde, dans la mesure où deux décharges électrostatiques successives peuvent être espacées de plusieurs heures ou de plusieurs jours. De cette manière, le procédé selon l'invention permet de prendre en compte chaque décharge électrostatique intervenant dans un local donné.

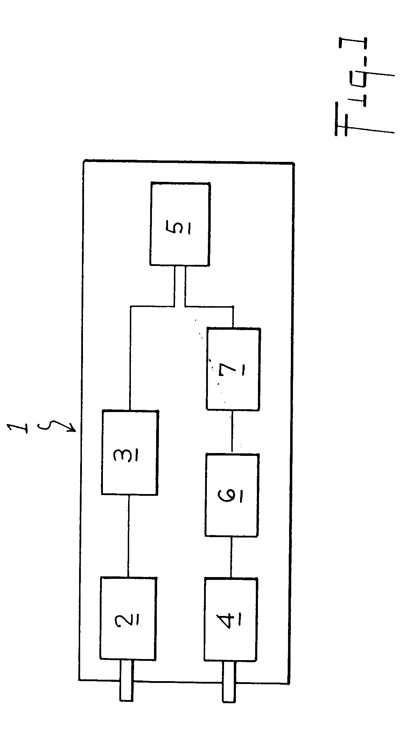

La **fig. 1** illustre un schéma-bloc fonctionnel d'un appareil **1** de détection conforme à l'invention comportant une sonde **2** de détection d'un champ électrostatique, reliée à un moyen **3** de détection de la variation du champ électrostatique préalablement détecté. L'appareil **1** comporte, également, un détecteur **4** d'un champ électromagnétique, relié à un moyen **5** d'avertissement de la présence simultanée de la variation du champ électrostatique et du champ électromagnétique.

De préférence, le détecteur **4** est connecté au moyen d'avertissement **5** par l'intermédiaire d'un étage **6** de détection du champ électromagnétique au-delà d'un seuil déterminé et d'un circuit **7** de maintien du signal issu de l'étage de détection **6**, pendant un intervalle de temps déterminé en relation avec le temps de réponse du moyen de détection **3**. L'étage de détection **6** permet de régler à volonté la sensibilité de l'appareil, tandis que le circuit de maintien **7** permet d'obtenir l'activation, pratiquement simultanée, du moyen d'avertissement **5** correspondant à une impulsion due à une décharge électrostatique.

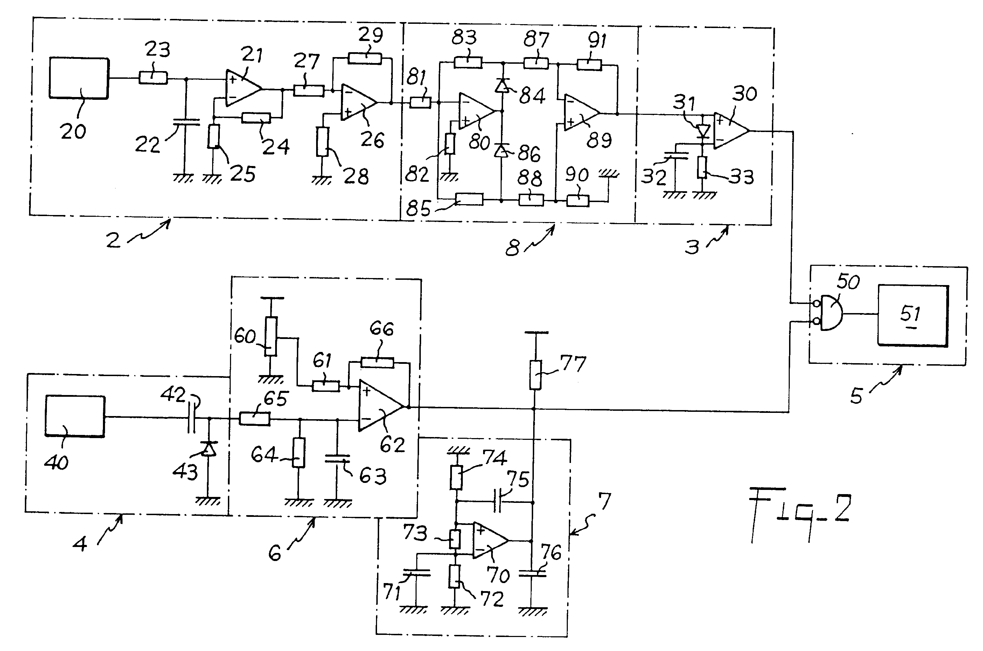

La **fig. 2** illustre un exemple de réalisation d'un appareil **1** de détection d'impulsions brèves dues à des décharges électrostatiques de mobilier ou humaines. L'appareil **1** comporte un capteur **20**, de tous types connus, tel qu'un conducteur métallique, conçu pour détecter un champ électrostatique. Le capteur **20** est relié, de façon classique, à un étage d'adaptation d'impédance constitué par un amplificateur opérationnel **21** dont l'entrée non inverseuse est reliée, d'une part, à la masse par un condensateur **22** et, d'autre part, au capteur **20** par l'intermédiaire d'une résistance **23**. L'entrée inverseuse de l'amplificateur **21** est connectée à la sortie de l'amplificateur par une résistance **24** et à une résistance **25** reliée à la masse.

L'étage d'adaptation d'impédance est suivi d'un étage d'amplification du signal détecté, constitué par un amplificateur opérationnel **26** dont l'entrée inverseuse est relié, par une résistance **27**, à la sortie de l'amplificateur opérationnel **21**. L'entrée non inverseuse de l'amplificateur **26** est reliée à la masse par une résistance **28**, tandis que l'entrée inverseuse est connectée à la sortie de l'amplificateur opérationnel **26** par une résistance **29**.

L'étage d'amplification est relié au moyen **3** de détection de la variation du champ électrostatique, par l'intermédiaire d'un redresseur **8** à double alternance sans seuil constitué par un amplificateur opérationnel **80**, dont l'entrée inverseuse est connectée par une résistance **81** à la sortie de l'amplificateur **26**, tandis que l'entrée non inverseuse est reliée à la masse par une résistance **82**. L'entrée inverseuse de l'amplificateur opérationnel **80** est reliée à la sortie de l'amplificateur par une première branche comportant une résistance **83** montée en série avec une diode **84** dont l'anode est connectée à la sortie de l'amplificateur opérationnel **80** et par une seconde branche comportant une résistance **85** montée en série avec une diode **86** dont la cathode est reliée à la sortie de l'amplificateur opérationnel **80**. La cathode de la diode **84** et l'anode de la diode **86** sont, respectivement, reliées par des résistances **87** et **88** à l'entrée inverseuse et à l'entrée non inverseuse d'un amplificateur opérationnel **89**. L'entrée non inverseuse de l'amplificateur opérationnel **89** est reliée à la masse par une résistance **90**, tandis que l'entrée inverseuse est connectée à la sortie de l'amplificateur opérationnel par une résistance **91**.

Le moyen de détection **3** est constitué par un amplificateur opérationnel **30** dont l'entrée non inverseuse est reliée, d'une part, à la sortie de l'amplificateur opérationnel **89** et, d'autre part, à l'anode d'une diode **31** dont la cathode est connectée à l'entrée inverseuse de l'amplificateur opérationnel **30**. L'entrée inverseuse de l'amplificateur opérationnel **30** est reliée à un condensateur **32** et à une résistance **33**, montés en parallèle et connectés à la masse. Le moyen de détection **3** est adapté pour déceler la première variation du champ électrostatique intervenant dans un temps inférieur à 1 milliseconde.

Le détecteur **4** est constitué d'un capteur **40** d'un champ électromagnétique formé, soit, par exemple, par une boucle métallique pour détecter la composante magnétique du champ, ou soit, par exemple, par une antenne pour déceler la composante électrique du champ. Le capteur **40** est relié à un étage de détection constitué par une capacité **42** connectée au capteur **40** et reliée à la cathode d'une diode **43** dont l'anode est connectée à la masse.

Il doit être noté que le capteur **40** peut être distinct du capteur **20** ou assumer ensemble les fonctions de détection des champs électrostatique et électromagnétique. Le capteur **40** peut donc être formé par une antenne constituée par un fil métallique présentant, par exemple, une longueur de l'ordre de 30 cm.

Le détecteur **4** est suivi par l'étage **6** de détection du champ électromagnétique au-delà d'un seuil déterminé par un potentiomètre **60** et correspondant à une valeur, par exemple égale à 1 ampère par mètre. Le curseur du potentiomètre est connecté par une résistance **61** à l'entrée non inverseuse d'un amplificateur opérationnel **62**. L'entrée inverseuse de l'amplificateur opérationnel **62** est connectée à un condensateur **63** relié à la masse, à une résistance **64** reliée à la masse et à une résistance **65** reliée à la cathode de la diode **43**. L'entrée non inverseuse de l'amplificateur opérationnel **62** est reliée, par une résistance **66**, à la sortie de l'amplificateur opérationnel **62** délivrant un signal qui est maintenu par le circuit **7**, de manière à obtenir une activation simultanée du moyen **5** par ce signal et celui délivré par l'amplificateur opérationnel du moyen de détection **3**.

Il doit être considéré que les capacités **42**, **63** et les résistances **64**, **65** prennent des valeurs adaptées pour constituer un filtre passe-haut dont la fréquence de coupure est comprise entre 15 MHz et 200 MHz.

Le circuit **7** de maintien du signal, constitué sous la forme d'un monostable, comporte un amplificateur opérationnel **70** dont l'entrée inverseuse est reliée à une capacité **71** et une résistance **72**, montées en parallèle et reliées à la masse. L'entrée non inverseuse de l'amplificateur opérationnel **70** est connectée à l'entrée inverseuse par une résistance **73**, à une tension positive par une résistance **74** et à la sortie de l'amplificateur opérationnel par une capacité **75**. La sortie de l'amplificateur opérationnel **70** est connectée par une capacité **76** à la masse, par une résistance **77** à une tension positive et à la sortie de l'amplificateur opérationnel **62** qui se trouve relié à une entrée d'une porte **ET 50** du moyen avertisseur **5**. L'autre entrée de la porte **50** est reliée à la sortie de l'amplificateur **30**. Le moyen avertisseur **5** comporte, également, un organe **51** relié à la porte **50** et permettant de mémoriser le signal de sortie issu de la porte **ET**, de manière à conserver dans le temps l'information. Un tel organe peut être de tout type connu, tel que, par exemple, un relais d'excitation d'un témoin lumineux ou un enregistreur.

L'appareil décrit ci-dessus est destiné à être placé dans un local en relation de proximité d'un matériel informatique pour permettre de détecter les décharges électrostatiques, dites de mobilier ou humaines, susceptibles d'intervenir dans son environnement, Un tel appareil est adapté pour déceler de telles décharges susceptibles d'apparaître dans la région alentour s'étendant jusqu'à une dizaine de mètres.

Le capteur **20** détecte le champ électrostatique et délivre un signal d'une valeur en relation avec le niveau du champ électrostatique détecté. Un tel signal, qui est amplifié et redressé, est apte à charger le condensateur **32**. Si le champ électrostatique diminue brusquement, en raison d'une décharge électrostatique, l'ensemble, constitué par la diode **31**, le condensateur **32** et la résistance **33**, génère une tension différentielle, de sorte qu'il apparaît, à la sortie de l'amplificateur opérationnel **30**, un signal de présence d'une variation du champ électrostatique. Il est à noter que la résistance **33** et le condensateur **32** présentent une constante de temps déterminée pour n'entraîner l'apparition d'un signal à la sortie de l'amplificateur opérationnel **30** que si la variation de champ électrostatique intervient dans un temps inférieur à 1 milliseconde. Ainsi, le moyen de détection **3** délivre un signal uniquement lorsque la variation du champ électrostatique est très rapide, correspondant, en particulier, à une décharge électrostatique, dite de mobilier ou humaine, et non pas pour de simples fluctuations du champ. En considérant une courbe représentant le champ électrostatique en fonction du temps, l'ensemble, constitué par le condensateur **32** et la résistance **33**, permet la détection lorsque la courbe présente une pente maximale.

L'apparition d'une décharge électrostatique se traduit par une impulsion brève générant un champ électromagnétique qui se trouve décelé par le détecteur **4**, si le champ électromagnétique présente une fréquence supérieure à 15 MHz. Le signal, issu du détecteur **4**, est comparé au seuil choisi de l'étage **6** pour engendrer, en cas de dépassement du seuil, un signal qui est appliqué à une entrée de la porte **ET 50**, pendant un intervalle de temps inférieur à 1 milliseconde. Ce signal est maintenu par le circuit **7** à l'entrée de la porte **ET 50**, jusqu'à ce que l'amplificateur opérationnel **30** délivre un signal, de manière à obtenir, simultanément, un signal sur les deux entrées de la porte **ET 50**. Le maintien du signal est nécessaire, en raison du temps de réponse plus long pour la détection de la variation du champ électrostatique par rapport à celui du champ électromagnétique. en effet, il doit être considéré qu'une décharge électrostatique humaine ou de mobilier est assimilable à une décharge d'un condensateur dont le temps de montée est de l'ordre de 1 nanoseconde et la largeur à mi-hauteur de l'ordre de 30 nanosecondes.

La présence simultanée d'un signal sur les deux entrées de la porte **ET 50** entraîne l'apparition d'un signal à la sortie de la porte **50** pouvant être mémorisé ou enregistré par l'organe **51** pour indiquer la présence et/ou le moment d'apparition d'une décharge électrostatique.

Un tel appareil permet de déceler, de manière simple, les impulsions brèves dues uniquement à des décharges électrostatiques de mobilier ou humaines. En effet, si une impulsion brève de commutation, ou une impulsion due à un orage, interviennent dans l'environnement du matériel informatique, la porte **ET 50** ne sera, au plus, activée sur son entrée reliée au détecteur **4** de champ électromagnétique et ne délivrera pas de signal d'excitation de l'organe **51**. La variation de champ électrostatique, due à l'orage, ne sera pas prise en compte, en raison du positionnement de l'appareil à l'intérieur d'un local.

Le dépistage de l'apparition des décharges électrostatiques, dites de mobilier ou humaines, apparaissant dans un local, permet de choisir des solutions techniques adaptées à ce type de phénomènes. Par exemple, il peut être envisagé de traiter les sols par des produits anti-statiques ou d'imposer le port de bracelet relié à la terre, aux personnes travaillant à proximité du matériel informatique.

L'invention n'est pas limitée aux exemples décrits et représentés, car diverses modifications peuvent y être apportées sans sortir de son cadre.

## Revendications

1. Procédé pour assurer la détection, à L'intérieur d'un local, d'impulsions résultant de décharges électrostatiques, notamment de mobilier ou humaines, selon lequel le champ électromagnétique est détecté à l'intérieur du local et filtré par un filtre passe-haut,
caractérisé en ce qu'il consiste à :
- détecter, à l'intérieur du local, d'une part, le champ électromagnétique par le filtre passe-haut dont la fréquence de coupure est comprise entre 15 et 200 MHz et, d'autre part, le champ électrostatique,
- détecter la première variation du champ électrostatique intervenant dans un temps inférieur à 1 milliseconde,
- et produire un signal d'avertissement lorsque la variation du champ électrostatique détectée et la présence du champ électromagnétique interviennent simultanément dans un intervalle de temps inférieur à 1 milliseconde permettant d'identifier une impulsion due à une décharge électrostatique mobilière ou humaine.

2. Procédé selon la revendication 1, caractérisé en ce qu'il consiste à détecter le champ électromagnétique au-delà d'un seuil déterminé égal à 1 ampère par mètre.

3. Procédé selon la revendication 1, caractérisé en ce qu'il consiste à détecter le champ électromagnétique par sa composante électrique.

4. Procédé selon la revendication 1, caractérisé en ce qu'il consiste à détecter le champ électromagnétique par sa composante magnétique.

5. Appareil pour la mise en oeuvre du procédé conforme aux revendications 1 à 4, comprenant:
- une sonde (**2**) de détection d'un champ électrostatique,
- un détecteur (**4**) d'un champ électromagnétique,
- un moyen (**3**) de détection de la variation du champ électrostatique intervenant dans un temps inférieur à 1 milliseconde,
- un moyen (**5**) d'avertissement de la présence, dans un intervalle de temps inférieur à 1 milliseconde, de la variation du champ électrostatique détectée et du champ électromagnétique, permettant l'identification d'une impulsions due à une décharge électrostatique, dite de mobilier ou humaine.

6. Appareil selon la revendication 5, caractérisé en ce qu'il comporte un étage (**6**) de détection du champ électromagnétique au-delà d'un seuil déterminé égal à 1 ampère par mètre.

7. Appareil selon les revendications 5 et 6, caractérisé en ce qu'il comporte un circuit (**7**) de maintien du signal issu de l'étage de détection du champ électromagnétique, pendant un intervalle de temps de 1 milliseconde en relation avec le temps de réponse nécessaire à la détection de la variation du champ électrostatique.

8. Appareil selon la revendication 5, caractérisé en ce que le moyen d'avertissement (**5**) est du type à mémoire ou à enregistrement.

## Patentansprüche

1. Verfahren zur Detektion innerhalb eines Bauwerks von Impulsen, die aus elektrostatischen Entladungen, insbesondere des Inventars oder von Menschen, resultieren, bei dem das elektromagnetische Feld innerhalb des Bauwerks detektiert und durch einen Hochpaßfilter gefiltert wird,
**gekennzeichnet** durch die Schritte:
- Detektieren, innerhalb des Bauwerks, zum einen des elektromagnetischen Feldes über den Hochpaßfilter, dessen Grenzfrequenz zwischen 15 MHz und 200 MHz liegt, und zum anderen des elektrostatischen Feldes,
- Detektieren der ersten Veränderung des elektrostatischen Feldes, die in einem Zeitraum von weniger als 1 Millisekunde stattfindet,
- Erzeugen eines Warnsignals, wenn die detektierte Veränderung des elektrostatischen Feldes und das Vorhandensein des elektromagnetischen Feldes gleichzeitig in einem Zeitintervall von weniger als 1 Millisekunde stattfinden, wodurch ein durch eine elektrostatische Entladung von Inventar oder Menschen verursachter Impuls identifiziert werden kann.

2. Verfahren nach Anspruch 1,
dadurch gekennzeichnet,
daß das elektromagnetische Feld oberhalb einer gegebenen Schwelle von 1 Ampere pro Meter detektiert wird.

3. Verfahren nach Anspruch 1,
dadurch gekennzeichnet,
daß das elektromagnetische Feld über seine elektrische Komponente detektiert wird.

4. Verfahren nach Anspruch 1,
dadurch gekennzeichnet,
daß das elektromagnetische Feld über seine magnetische Komponente detektiert wird.

5. Vorrichtung zur Anwendung des Verfahrens nach einem der Ansprüche 1 bis 4, mit:
- einer Sonde (2) zur Detektion eines elektrostatischen Feldes,
- einem Detektor (4) für ein elektromagnetisches Feld,
- einer Einrichtung (3) zur Detektion einer in einem Zeitraum von weniger als 1 Millisekunde stattfindenden Veränderung des elektrostatischen Feldes,
- einer Einrichtung (5) zum Anzeigen des Vorhandenseins, in einem Zeitraum von weniger als 1 Millisekunde, der detektierten Veränderung des elektrostatischen Feldes und des elektromagnetischen Feldes, was die Identifikation eines durch eine elektrostatische Entladung von Inventar oder Menschen verursachten Impulses ermöglicht.

6. Gerät nach Anspruch 5,
gekennzeichnet durch
eine Stufe (6) zur Detektion des elektromagnetischen Feldes oberhalb einer gegebenen Schwelle von 1 Ampere pro Meter.

7. Gerät nach einem der Ansprüche 5 oder 6,
gekennzeichnet durch
eine Schaltung (7) zum Halten des von der Stufe zur Detektion des elektromagnetischen Feldes in einem Zeitraum von 1 Millisekunde ausgegebenen Signals in Beziehung zur für die Detektion der Veränderung des elektrostatischen Feldes notwendigen Reaktionszeit.

8. Gerät nach Anspruch 5,
dadurch gekennzeichnet,
daβ die Anzeigeeinrichtung (5) eine Speicher- oder Aufzeichnungseinrichtung ist.

## Claims

1. Method for detecting pulses inside premises, which pulses are the result of electrostatic discharges, notably from furniture or humans, according to which the electromagnetic field is detected inside the premises and filtered by a high-pass filter, characterized in that it consists in:
- detecting, inside the premises, on the one hand, the electromagnetic field by the high-pass filter whose cut-off frequency is comprised between 15 and 200 MHz and, on the other hand, the electrostatic field,
- detecting the first variation of the electrostatic field occurring within a period of time less than 1 millisecond,
- and producing a warning signal when the variation of the electrostatic field detected and the presence of the electromagnetic field occur simultaneously in an interval of time less than 1 millisecond, making it possible to identify a pulse due to a so-called furniture or human electrostatic discharge.

2. Method according to claim 1, characterized in that it consists in detecting the electromagnetic field beyond a determined threshold equal to 1 ampere per metre.

3. Method according to claim 1, characterized in that it consists in detecting the electromagnetic field by its electrical component.

4. Method according to claim 1, characterized in that it consists in detecting the electromagnetic field by its magnetic component.

5. Apparatus for carrying out the method according to claims 1 to 4, comprising:
- a sensor (2) for detecting an electrostatic field,
- a detector (4) for detecting an electromagnetic field,
- means (3) for detecting the variation of the electrostatic field occurring in a period of time of less than 1 millisecond,
- means (5) for warning about the presence, in an interval of time of less than 1 millisecond, of the variation of the electrostatic field detected and of the electromagnetic field, allowing identification of a pulse due to an electrostatic discharge so-called from furniture or human beings.

6. Apparatus according to claim 5, characterized in that it comprises a stage (6) for detection of the electromagnetic field beyond a determined threshold equal to 1 ampere per metre.

7. Apparatus according to claims 5 and 6, characterized in that it comprises a circuit (7) for holding the signal issuing from the stage of detection of the electromagnetic field, during an interval of time of 1 millisecond in relation with the response time necessary for detecting the variation of the electrostatic field.

8. Apparatus according to claims 5 and 6, characterized in that the warning means (5) is of the memory or recording type.
